(19) Europäisches Patentamt / European Patent Office / Office européen des brevets

(11) **EP 2 637 032 A1**

(12) **EUROPEAN PATENT APPLICATION**
published in accordance with Art. 153(4) EPC

(43) Date of publication:
**11.09.2013 Bulletin 2013/37**

(51) Int Cl.:
***G01R 31/36*** (2006.01)   ***H01M 10/48*** (2006.01)

(21) Application number: **11837841.3**

(22) Date of filing: **12.10.2011**

(86) International application number:
**PCT/JP2011/073425**

(87) International publication number:
**WO 2012/060190 (10.05.2012 Gazette 2012/19)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **04.11.2010 JP 2010247675**

(71) Applicant: **Mitsubishi Heavy Industries, Ltd.
Tokyo 108-8215 (JP)**

(72) Inventor: **UCHIDA Masataka
Tokyo 108-8215 (JP)**

(74) Representative: **HOFFMANN EITLE
Patent- und Rechtsanwälte
Arabellastrasse 4
81925 München (DE)**

(54) **BATTERY ABNORMALITY PREDICTION SYSTEM**

(57)    A battery abnormality prediction system includes a normal range determination unit which acquires parameter values representing the states of a plurality of unit cells (11a to 11-n (where n is a natural number equal to or greater than 2)) and determines whether or not the acquired parameter values are normal values, a statistical processing unit which sorts a plurality of parameter values determined to be normal values into ranges divided at predetermined intervals and performs statistical processing on the sorted parameter values, and a state determination unit which determines the states of the plurality of unit cells based on the result of the statistical processing in the statistical processing unit and determines whether or not the plurality of unit cells are in a state of being able to transit from a normal state to an abnormal state based on the determination result.

FIG. 2

**Description**

Technical Field

The present invention relates to a battery abnormality prediction system in which a cell assembly having a plurality of unit cells is mounted.
Priority is claimed on Japanese Patent Application No. 2010-247675, filed November 4, 2010, the content of which is incorporated herein by reference.

Background Art

In the related art, for example, a cell assembly having a plurality of unit cells (for example, secondary batteries) is used in a battery system of an electric vehicle. In the cell assembly mounted in the battery system, charging/discharging is performed on an individual secondary battery having a predetermined capacity, and a power load is activated using power generated by charging/discharging. However, after charging/discharging is repeatedly performed, the capacity (also referred to as "residual capacity") of each secondary battery may individually have a different value due to manufacturing variation of each secondary battery or the usage environment, such as temperature or humidity. If charging/discharging is repeatedly performed on the secondary batteries having different residual capacities, a specific secondary battery may be deteriorated quickly compared to other secondary batteries.

For this reason, a technique which measures the internal resistance value of each secondary battery and controls charging/discharging while detecting the deterioration of each secondary battery based on the measured internal resistance value has been developed (for example, see Patent Document 1). This technique improves the performance or reliability of the secondary battery or the cell assembly using a plurality of secondary batteries.

A technique in which, when abnormality occurs in any secondary battery, a user (equipment/system to be driven by a unit cell or a user of the equipment/system) is given a warning (display) about abnormality of the secondary battery (for example, see Patent Document 2).

Citation List

Patent Documents

Patent Document 1: Japanese Patent Application, First Publication No. 2008-118790
Patent Document 2: Japanese Patent Application, First Publication No. 2003-125540

Summary of Invention

Technical Problem

However, in the technique of the related art illustrated in Patent Document 2, the user is given a warning after it is detected that a secondary battery is in an abnormal state. For this reason, when a warning about the occurrence of abnormality of a secondary battery is received and the equipment/ system should be inevitably stopped in response to the warning, the battery system cannot be operated despite the necessity of operating the battery system at the current point of time. From this point, while a case where a backup secondary battery is reserved in the battery system is considered, in this case, there is a need for continuous development for switching control of the reserved secondary battery.

It cannot be said that this phenomenon is preferable for the battery system, and for example, if it is assumed that an abnormality occurs in a cell assembly mounted in an electric vehicle which is traveling at high speed, there is a need for improvement from the viewpoint of safety.
The invention has been accomplished in consideration of the problem in the related art as an example, and an object of the invention is to provide a battery system with improved safety or convenience.

Solution to Problem

A battery abnormality prediction system of the invention includes a normal range determination unit which acquires parameter values representing the states of a plurality of unit cells and determines whether or not the acquired parameter values are normal values, a statistical processing unit which sorts a plurality of parameter values determined to be normal values in ranges divided at predetermined intervals and performs statistical processing on the sorted parameter values, and a state determination unit which determines the states of the plurality of unit cells based on the result of the statistical processing in the statistical processing unit and determines whether or not the plurality of unit cells are in a state of being able to transit from a normal state to an abnormal state based on the determination result.

Advantageous Effects of Invention

According to the invention, it is possible to predict a unit cell which is likely to fall into an abnormal state before a plurality of unit cells mounted in a system fall into the abnormal state while suppressing a processing load necessary for determination. Therefore, it is possible to realize a battery system having an excellent degree of safety.

Brief Description of Drawings

FIG. 1 is a block diagram showing the configuration of a secondary battery abnormality prediction system according to this embodiment.

FIG. 2 is a functional block diagram showing connection of battery cells and the connection relationship between a cell assembly and CMU and BMU according to this embodiment.

FIG. 3 is a diagram showing an example of voltage values of a first battery cell to a 20th battery cell acquired by a voltage acquisition unit according to this embodiment.

FIG. 4 is a flowchart showing a procedure for determining cell assembly abnormality prediction according to this embodiment.

FIG. 5 is a flowchart showing prediction determination in the procedure for determining cell assembly abnormality prediction according to this embodiment.

FIG. 6 is an example of a diagram (normal distribution) showing the voltage distribution of a cell assembly in the form of a bar graph according to this embodiment.

FIG. 7 is an example of a diagram (a distribution having two maximum values) showing the voltage distribution of a cell assembly in the form of a bar graph according to this embodiment.

Description of Embodiments

Hereinafter, a battery system according to the invention will be described in detail with reference to the drawings.

[First Embodiment]

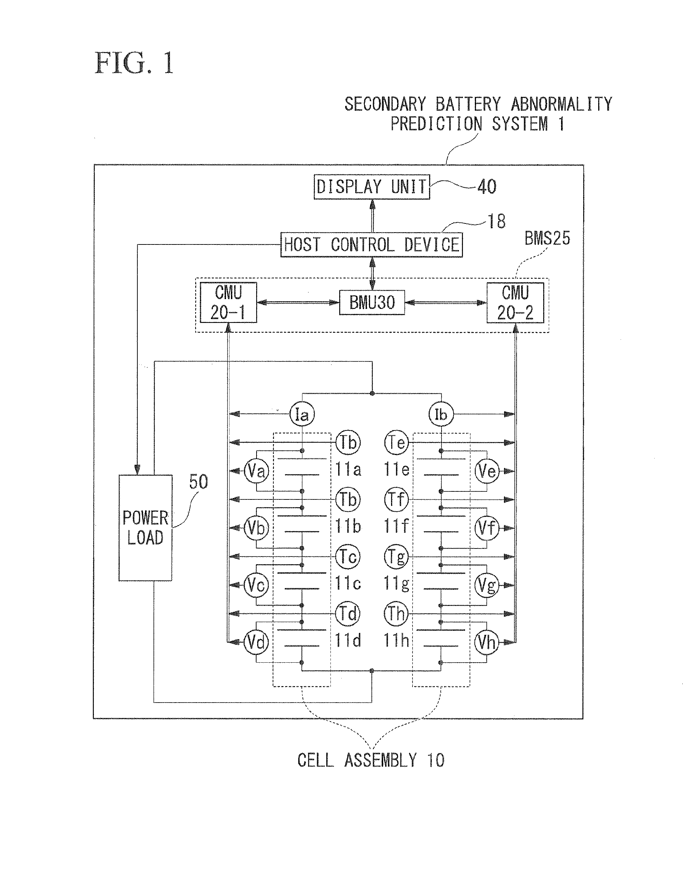

FIG. 1 is a block diagram showing the configuration of a battery system according to this embodiment. The battery system of this embodiment has a function of indicating (predicting) that, before unit cells (for example, second batteries) constituting a cell assembly cause abnormality, the unit cells are in a state of being able to transit from a normal state to an abnormal state. Hereinafter, a battery system having this function is referred to as "battery abnormality prediction system", and a specific configuration will be described with a secondary battery abnormality prediction system mounted with secondary batteries as an example.

FIG. 1 is a block diagram showing the configuration of a secondary battery abnormality prediction system 1 according to this embodiment.

The secondary battery abnormality prediction system 1 is, for example, an electric vehicle. The secondary battery abnormality prediction system 1 includes a cell assembly 10, a host control device 18, a display unit 40, a power load 50, and a BMS (Battery Management System) 25. The cell assembly 10 and the BMS 25 which is a monitoring control device of the cell assembly may be be constituted as a single battery module (not shown), and are embedded inside the secondary battery abnormality prediction system 1 from the outside of the secondary battery abnormality prediction system 1. With the use of the battery module, the battery module can be easily replaced from the outside of the secondary battery abnormality prediction system 1.

The power load 50, the host control device 18, and the display unit 40 are embedded in the secondary battery abnormality prediction system 1 in advance. In the secondary battery abnormality prediction system 1, the host control device 18 and the BMS 25 may be simply referred to as a control device.

The secondary battery abnormality prediction system 1 (battery system) of the invention may be, for example, a mobile object, for example, an industrial vehicle, such as a forklift, a trolley, or a mobile object, such as an airplane or a ship in which a propeller or a screw is connected to an electric motor as the power load 50, in addition to an electric vehicle. The secondary battery abnormality prediction system 1 may be, for example, a stationary system, such as a household power storage system or a system interconnection facilitation electric storage system combined with natural energy generation, such as a windmill or sunlight. That is, the secondary battery abnormality prediction system 1 collectively refers to a system which uses power charging/discharging of a plurality of secondary batteries constituting the cell assembly 10.

The cell assembly 10 includes secondary batteries 11a to 11h as a plurality of unit cells, and supplies power to the power load 50 of the secondary battery abnormality prediction system 1. In this embodiment, a plurality of secondary batteries 11 a to 11d and 11e to 11h are connected in series (each set is referred to as "battery row"), and the battery rows are connected in parallel, thereby constituting the cell assembly 10. Hereinafter, the secondary batteries 11 a to 11h are collectively referred to as "secondary battery 11 ". In this case, adjacent batteries in parallel are connected together through, for example, a switch, and during prediction determination processing described below, a state determination unit 33 (described below) in the BMU 30 appropriately releases connection so as to exclude the influence of the other row, and prediction determination may be performed for each battery row.

Various sensors which measure measurement information, such as a temperature value, a voltage value, and a current value, are attached to each secondary battery 11, and the measurement information measured by and output from these sensors is input to the BMS 25 described below in detail. Hereinafter, in regard to the secondary battery 11, a laminated lithium-ion secondary battery in which a plurality of positive plates and a plurality of negative plates are alternately laminated through a separator and accommodated in a battery case will be described as an example. However, the invention is not limited to the laminated lithium-ion secondary battery, and other batteries including a wound lithium-ion secondary battery in which strip-shaped positive and negative plates are wound in a battery case through a separator and a primary battery may be used.

The host control device 18 controls the power load 50 in accordance with an instruction from a user (for example, the amount of stepping of an accelerator of the user), receives associated information of the cell assembly 10 transmitted from the BMS 25 (which is information associated with the measurement information and includes the charging rate SOC of each secondary battery 11 calculated by the BMS 25, or the like), and controls the display unit 40 such that the associated information is appropriately displayed on the display unit 40. The host control device 18 outputs a determination start signal to the BMS 25 at a predetermined timing so as to allow the BMS 25 to perform prediction determination processing described below. The predetermined timing may be, for example, every several seconds, every several minutes, or every predetermined time, such as every one hour or every 24 hours, or the determination start signal may be output irregularly (for example, when the user gives an instruction to start deterioration determination).

When it is determined that at least part of the associated information is an abnormal value, the host control device 18 gives a warning to the user. Specifically, an abnormality lamp embedded in the display unit 40 is turned on (since it should suffice that optical display is performed, display to the effect that an abnormality occurs may be performed on a screen of a monitor described below), and an acoustic device, such as a buzzer, embedded in the display unit 40, operates to sound an alarm and stimulates a sense of vision and a sense of hearing by light and sound to draw a user's attention.

The display unit 40 is, for example, a monitor, such as a liquid crystal panel, including the acoustic device, and displays the associated information of each secondary battery 11 constituting the cell assembly 10 under the control of the host control device 18. The display unit 40 is an example of a "notification unit" in this specification, and as the notification unit, for example, the buzzer or a speaker described below may be used.

The power load 50 is an electric motor connected to the wheels of an electric vehicle or a power converter, such as an inverter. The power load 50 may be an electric motor which drives a windshield wiper or the like.

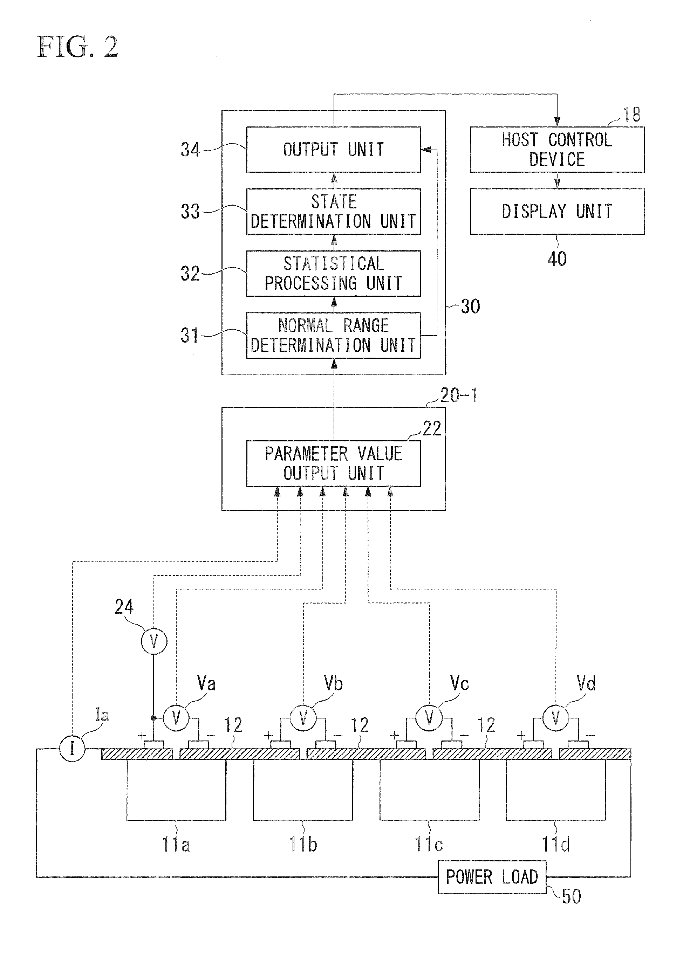

Next, the connection relationship between a CMU (Cell Monitor Unit) 20 and a BMU 30 (Battery Management Unit) constituting the BMS 25 and the connection relationship between each secondary battery 11 and the CMU 20 will be described in detail with reference to FIG. 2.

In this embodiment, as shown in FIG. 1, CMUs 20-1 and 20-2 are respectively provided in the battery rows. Hereinafter, the CMUs 20-1 and 20-2 are collectively referred to as "CMU 20". For simplification of description, the secondary batteries 11e to 11h and the CMU 20-2 are the same as the secondary batteries 11a to 11d and the CMU 20-1, thus description thereof will be omitted. Description will be continued as to the secondary batteries 11 a to 11d and the CMU 20-1.

The CMU 20 includes an ADC (Analog Digital Converter) (not shown), and receives a plurality of types of measurement information detected by and output from various sensors provided in each secondary battery 11 as analog signals. The CMU 20 converts the analog signals to corresponding digital signals using the ADC, and outputs the digital signals to the BMU 30 as a plurality of parameter values for calculating associated information or prediction determination (described below).

Next, an installation form of various sensors will be described. As shown in FIG. 2, voltmeters Va to Vd are provided to correspond to the secondary batteries 11a to 11d on a one-to-one basis. Specifically, each of the voltmeters Va to Vd is connected between the anode terminal and the cathode terminal of the corresponding secondary battery 11. The voltmeters Va to Vd measure the voltage values of the secondary batteries 11.

As shown in FIG. 1, thermometers Ta to Td are provided to correspond to the secondary batteries 11a to 11d on a one-to-one basis. Specifically, each of the thermometers Ta to Td is provided on the outer surface of the battery case of the corresponding secondary battery 11 (the installation position may be arbitrarily selected). The thermometers Ta to Td measure the temperature values of the secondary batteries 11.

In order to measure the maximum voltage which can be applied to the power load 50, a voltmeter 24 is connected between the anode terminal and the cathode terminal of the cell assembly 10. In this embodiment, for example, the voltmeter 24 is connected between the anode terminal of the secondary battery 11a and the cathode terminal of the secondary battery 11d at both ends of a predetermined battery row (a configuration in which the secondary batteries 11a to 11d are connected in series by a bus bar 12).

An ammeter Ia which measures a current value flowing in the cell assembly 10 is provided between the cell assembly 10 and the power load 50. The ammeter Ia and the voltmeter 24 are examples of various sensors.

In addition, the potential of the battery case in the secondary battery 11 may be measured as the measurement information. Specifically, the anode terminal of each secondary battery 11 and the battery case are electrically connected together through a predetermined resistor. A voltmeter for case voltage measurement is connected to the cathode terminal of each secondary battery 11 and the battery case. Accordingly, the potential (referred to as "can potential") of the battery case in the secondary battery 11 can be measured.

The CMU 20 which is connected to each secondary battery 11 includes a parameter value output unit 21.

The parameter value output unit 21 detects the voltage value, the temperature value, and the can potential of each secondary battery 11, and the measurement information, such as the voltage value of the entire cell assembly 10 acquired from the voltmeter 24 or the current value acquired from the ammeter Ia. The parameter value output unit 21 includes the ADC, converts the detected measurement information to digital signals using the ADC, and outputs the digital signals to the BMU 30 as parameter values.

The BMU 30 performs prediction determination processing described below based on the parameter values of the cell assembly 10 and each secondary battery 11 input from the CMU 20 each time the determination start signal is input from the host control device 18, and outputs the determination result to the host control device 18.

As shown in FIG. 2, the BMU 30 includes a normal range determination unit 31, a statistical processing unit 32, a state determination unit 33, and an output unit 34.

The BMU 30 is connected to the CMU 20 and the host control device 18 through a bus (not shown) for data transmission/reception with respect to the CMU 20 and the host control device 18, and controls the start or stop of power supply to the power load 50 in accordance with an instruction of the host control device 18.

Next, prediction determination processing which is executed by the BMS 25 will be described in detail based on the configuration of the BMU 30.

Hereinafter, as an example of prediction determination which is performed by the BMS 25 (in this embodiment, the BMU 30 constituting the BMS 25), a procedure for performing prediction determination based on the state of the voltage value of the cell assembly 10 according to this embodiment will be described. While the BMS 25 can perform prediction determination based on other kinds of parameter values (the temperature value or the can potential of each secondary battery 11), this is the same as prediction determination based on the voltage value, description thereof will be omitted.

For ease of understanding of the gist of this embodiment, in the cell assembly 10, it is assumed that 20 (n=20) secondary batteries 11 (first secondary battery 11a to 20th secondary battery 11t) are connected in series, and one CMU 20 is connected to the cell assembly 10. It is assumed that, as examples of various sensors, a first voltmeter Va to a 20th voltmeter Vt are respectively connected to the first secondary battery 11a to the 20th secondary battery 11t.

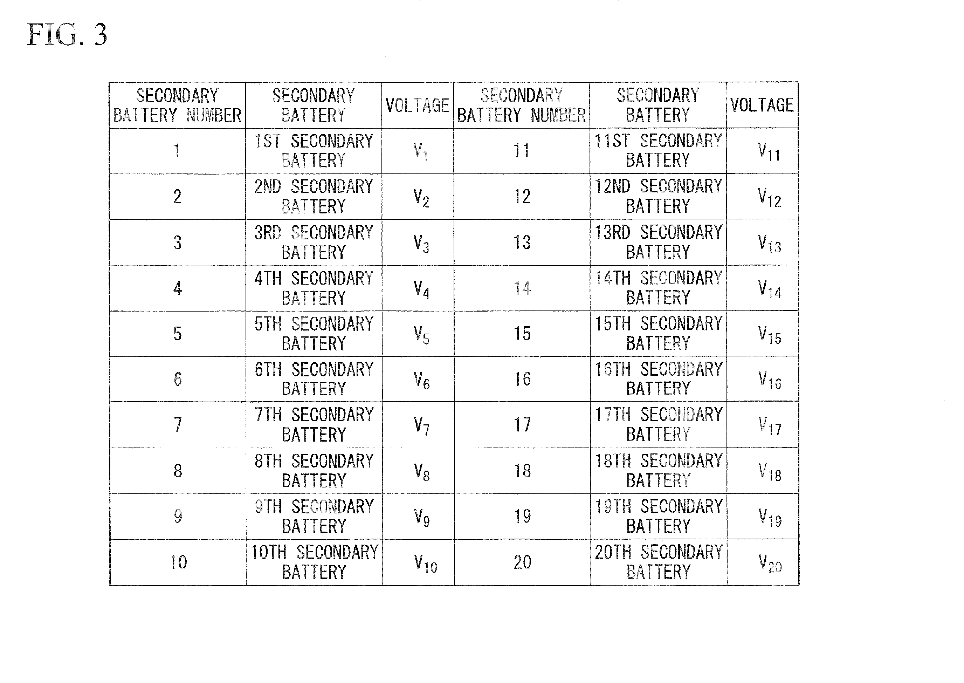

FIG. 3 is a diagram showing an example of the voltage values of the first secondary battery 11a to the 20th secondary battery 1 1t acquired by the parameter value output unit 21 of the CMU 20. The parameter value output unit 21 acquires the voltage values of the first secondary battery 11 a to the 20th secondary battery 11t in a predetermined period defined in advance, for example, at an interval of one second. In this embodiment, as shown in FIG. 3, the number of the secondary battery 11 and the voltage value of the secondary battery 11 are associated with each other. Specifically, since the cell assembly 10 has serial connection, for example, the voltage value between the negative electrode of the 20th secondary battery 11t and the positive electrode of the secondary battery 11 corresponding to a predetermined number is measured, thereby specifying the position of the secondary battery 11 of the predetermined number. Accordingly, the BMS 25 associates the position (corresponding to the predetermined number) of the secondary battery 11 with the voltage value of the secondary battery 11 corresponding to the position.

The normal range determination unit 31 based on a plurality of parameter values (the temperature value, the can voltage, or the like, and in this embodiment, a plurality of voltage values) output from the parameter value output unit 21, and determines whether or not each parameter value is within a predetermined range defined in advance.

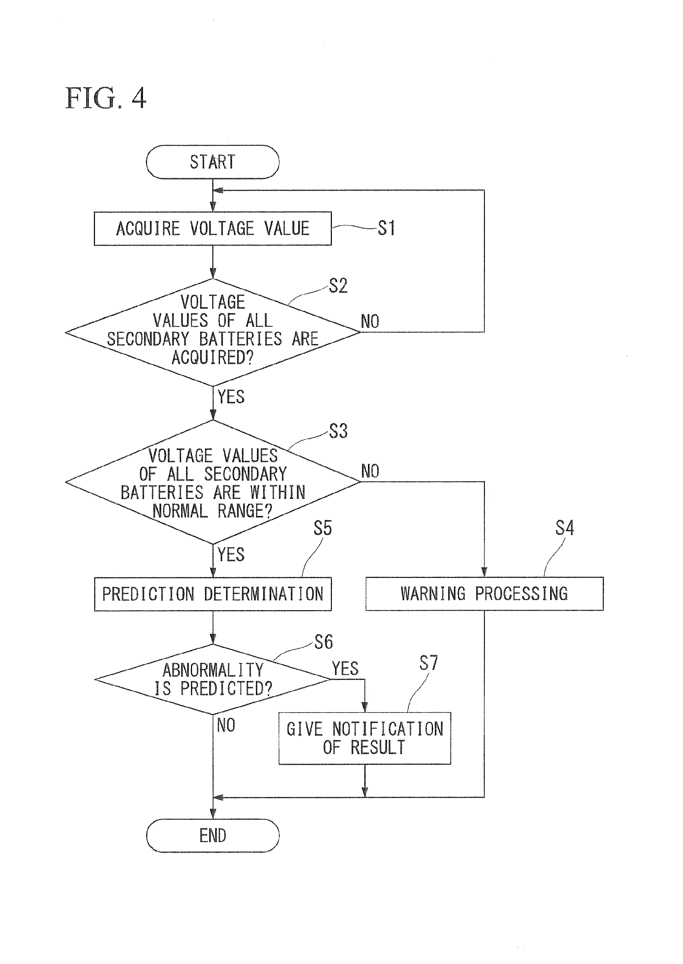

A specific determination form is as follows. That is, as shown in FIG. 4, the parameter value output unit 21 acquires the voltage value of each secondary battery 11 constituting the cell assembly 10 (Step S1). At this time, the CMU 20 associates the position of each secondary battery 11 constituting the cell assembly 10 with the voltage of the corresponding secondary battery 11 (see FIG. 3).

The parameter value output unit 21 determines whether or not all voltage values are acquired for the first secondary battery 11 a to the 20th secondary battery 11t (Step S2).

When all voltage values are not acquired (Step S2; No), Steps S1 and S2 are repeated until all voltage values are acquired.

When all voltage values are acquire (Step S2; Yes), the parameter value output unit 21 converts the acquired voltage values (voltage values $V_1$ to $V_{20}$) to parameter values as digital signals, and outputs the parameter values to the normal range determination unit 31 of the BMU 30.

The normal range determination unit 31 determines whether or not all input parameter values are within a normal range (within a predetermined range) (Step S3). The term "within a predetermined range" refers to a state where each secondary battery 11 constituting the cell assembly 10 sufficiently satisfies a supposed specification, and has a value set in advance by the manufacturer of the secondary battery 11. Information (an upper limit value Vp and a lower limit value Vs of a voltage) representing the predetermined range is recorded in a memory (not shown) of the BMU 30 in advance.

Accordingly, the normal range determination unit 31 reads the upper limit value Vp and the lower limit value Vs, and determines whether or not the voltage values ($V_1$ to $V_{20}$) of all of the secondary batteries 11a to 11t are greater than or equal to the lower limit value Vs and less than or equal to the upper limit value Vp. When it is determined that the voltage values of all of the secondary batteries 11 are greater than or equal to the lower limit value Vs and smaller than or equal to the upper limit value Vp, the normal range determination unit 31 determines that the voltage values of all of the secondary batteries 11 constituting the cell assembly 10 are in the normal state.

When all of the voltage values $V_1$ to $V_{20}$ are within the normal range (Step S3; Yes), the normal range determination unit 31 outputs the voltage values $V_1$ to $V_{20}$ to the statistical processing unit 32. The BMS 25 performs prediction determination described below based on the voltage values $V_1$ to $V_{20}$ (Step S5). When any one of the voltage values $V_1$ to $V_{20}$ is outside the normal range (Step S3; No), the BMU 30 performs control such that the determination result that the corresponding secondary battery 11 is at a voltage level outside the normal range (that is, abnormal voltage) is output to the display unit 40 as warning display (Step S4). At this time, the BMU 30 may perform control to limit the output of the cell assembly 10 (for example, to limit the output from the cell assembly 10 to 50%, to gradually fall down the output to zero, or the like). The BMU 30 may give a warning by sound from a speaker or the like in the electric vehicle, instead of or in addition to warning display.

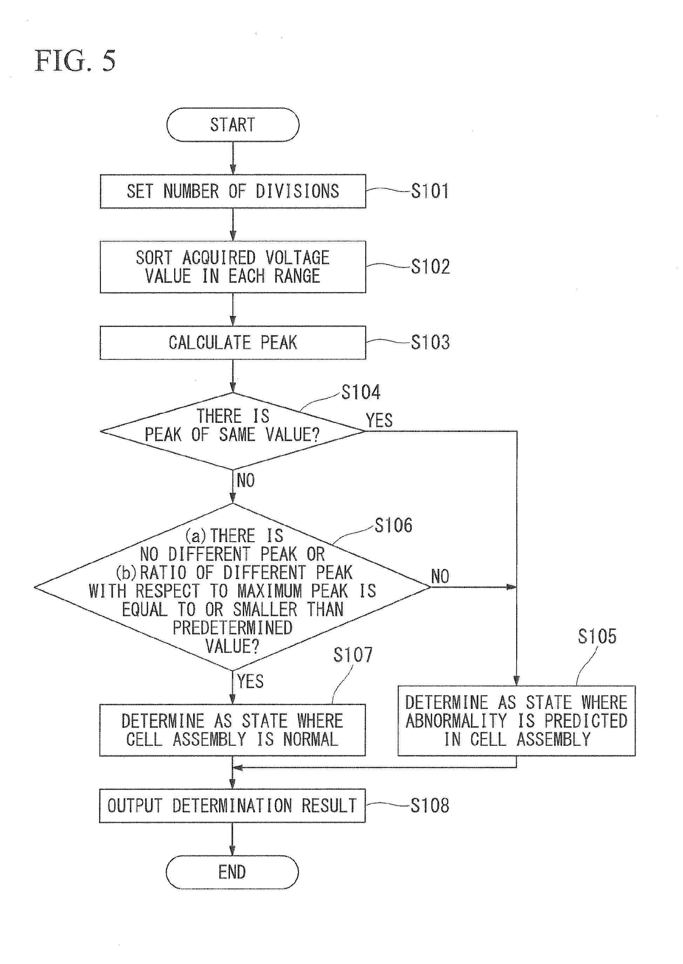

Next, description of prediction determination which is performed by the BMS 25 will be continued with reference to FIG. 5 or the like. In this embodiment, the BMS 25 generates a frequency distribution based on a plurality of parameter values (voltage values) determined to be within the normal range, and simply determines whether or not the frequency distribution is a normal distribution, thereby predicting abnormality of the cell assembly 10. Hereinafter, prediction determination will be described in detail.

The parameter values of each secondary battery 11 (the temperature value, the voltage value, and the can potential of each secondary battery 11, the voltage value or the current value of the entire cell assembly 10, or the like) are input from the normal range determination unit 31 to the statistical processing unit 32. The statistical processing unit 32 performs statistical processing (generates a frequency distribution) based on the input voltage values, and outputs information subjected to the statistical processing to the state determination unit 33. The statistical processing unit 32 may perform statistical processing in the same manner for other parameter values, and may output information (described below) subjected to the statistical processing to the state determination unit 33.

Specific statistical processing is performed as follows. That is, first, the statistical processing unit 32 sets the number N of divisions for sorting all of the input voltage values $V_1$ to $V_{20}$ (Step S101). The number N of divisions is a positive integer, and is set, for example, based on Expression (1).

$$(V_p\text{-}V_s):W1 \cong N:1 \ldots (1)$$

Here, W1 is a voltage value of a predetermined width in a frequency distribution described below, and is calculated in advance by an experiment or the like. As shown in Expression (1), W1 is defined as the ratio of the width of the upper limit value Vp and the width of the lower limit value Vs, and is used as an index for determining whether or not the frequency distribution is a normal distribution. If the value of W1 decreases, the number N of divisions increases, and a plurality of parameter values are sorted in smaller divided ranges.

On the other hand, the gist of this embodiment resides in that abnormality prediction of the cell assembly 10 is performed simply while suppressing a processing load of the BMS 25 (the details will be described below). From this viewpoint, in this embodiment, the value of W1 is set to be comparatively large. For example, if the upper limit value Vp and the lower limit value Vs are 4.2 V and 2.7 V, and W1 is 0.3 V, the number N of divisions becomes 5 from Expression (1).

Although a case where the number of divisions is 5 will be described below, the upper limit value Vp, the lower limit value Vs, W1, and the number N of divisions described above are examples, and may be of source appropriately set in accordance with the specification of the secondary battery 11 or the secondary battery abnormality prediction system.

The number of divisions corresponding to the difference between the upper limit value Vp and the lower limit value Vs of the voltage value may be stored in a memory (not shown) in advance in association with the difference. In this case, for example, the number of divisions may be stored in the memory (not shown) of the BMU 30 in advance such that the number of divisions corresponding to the difference $\Delta T1$ is 5, and the number of divisions corresponding to the difference $\Delta T2$ is 7.

The statistical processing unit 32 sorts the acquired voltage values as a frequency distribution in which the horizontal axis represents a voltage value and the vertical axis represents a frequency based on the calculated number N of divisions (the number of samples) (Step S102).

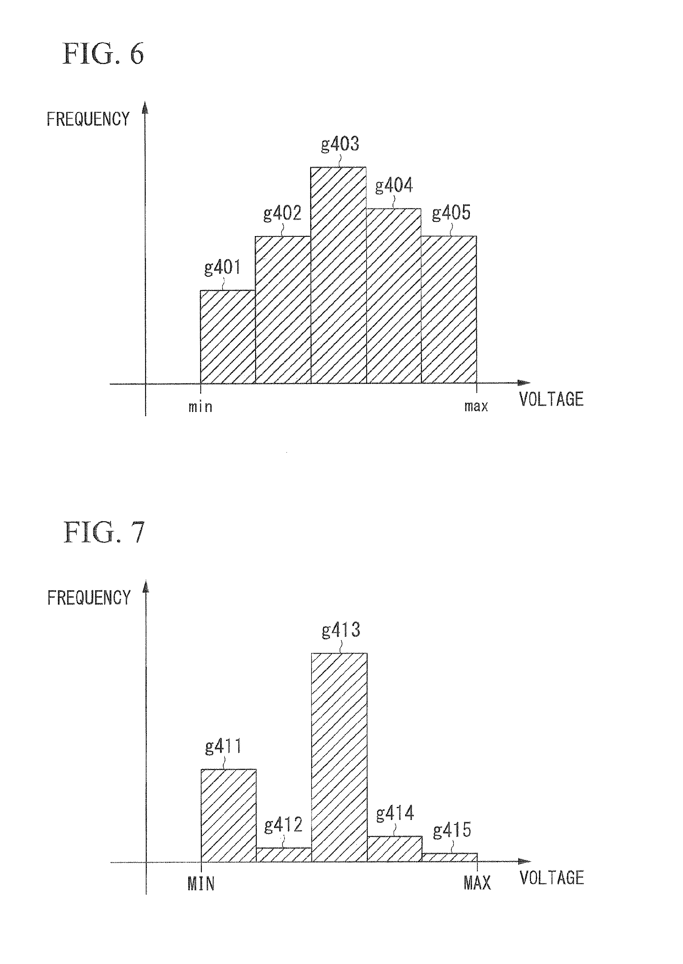

FIG. 6 shows an example of the frequency distribution. In the bar graph shown in FIG. 6, the vertical axis represents a frequency, and the horizontal axis represents a voltage value. Of theses, a bar g401 represents a frequency of a voltage value extracted as a first range. A bar g402 represents a frequency of a voltage value extracted as a second range. A bar g403 represents a frequency of a voltage value extracted as a third range. A bar g404 represents a frequency of a voltage value extracted as a fourth range. A bar g405 represents a frequency of a voltage value extracted as a fifth range. In this embodiment, the upper limit value Vp is 4.2 V, the lower limit value Vs is 2.7 V, and the number of divisions is 5. Accordingly, the first range becomes 2.7 V≤first range<3.0 V, the second range becomes 3.0 V≤second range<3.3 V, the third range becomes 3.3 V≤third range<3.6 V, the fourth range becomes 3.6 V≤fourth range<3.9 V, and the fifth range becomes 3.9 V≤fifth range≤4.2 V.

Next, the statistical processing unit 32 counts each acquired voltage value in each range (counts a frequency P). The statistical processing unit 32 outputs the frequency Pn (1≤n≤N) of each of the calculated ranges (the first range to the N-th range (in this embodiment, N is "5")) to the state determination unit 33 in association with the range number of the range where each frequency Pn is calculated.

Next, the state determination unit 33 calculates the peak of the frequency distribution based on the frequency distribution created by the statistical processing unit 32 (Step S103) .

Specifically, the state determination unit 33 which receives the frequency of each range first calculates the difference Zn (where n is a positive integer and 1≤n≤N) in frequency between the n- th range and the (n- 1) th range from among N sorted ranges in an ascending order of the voltage value, and determines whether the calculated difference Zn in frequency is a positive value, a negative value, or 0. That is, if the frequency which belongs to the n- th range from a range having a lower voltage value from among the ranges in the frequency distribution is Pn, the state determination unit 33 calculates the difference Zn in frequency using General Expression (2) .

$$Z_{(n)}=P_{(n)}-P_{(n-1)} \ (1 \leq n \leq N) \ \dots \ (2)$$

However, $P_{(0)}=0$.

For example, in the example shown in FIG. 6, the calculation of the difference Zn in frequency between the five divided ranges is as follows. That is, a left end $Z_{(1)}$ becomes "the frequency $P_1$- 0 belonging to the first range=positive value", $Z_{(2)}$ becomes "the frequency $P_2$ belonging to the second range- the frequency $P_1$ belonging to the first range=positive value", $Z_{(3)}$ becomes "the frequency $P_3$ belonging to the third range- the frequency $P_2$ belonging to the second range=positive value", $Z_{(4)}$ becomes "the frequency $P_4$ belonging to the fourth range- the frequency $P_3$ belonging to the third range=negative value", and $Z_{(5)}$ becomes "the frequency $P_5$ belonging to the fifth range- the frequency $P_4$ belonging to the fourth range=negative value".

The state determination unit 33 specifies points where the value of the calculated difference Zn in frequency inflects, for example, two adjacent ranges where the value of the difference changes from positive to negative from among the first range to the N-th range. When a set of the bar graph of the first range to the N-th range is supposed to be a crest, the state determination unit 33 recognizes and stores that the bar graph of a range having a small range number from among the two ranges corresponds to the peak of the crest. For example, in the example of the frequency distribution shown in FIG. 6, the value of the difference changes from positive to negative between the differences $Z_{(3)}$ and $Z_{(4)}$ in frequency, and the range to be specified is the third range and the fourth range. Accordingly, when a set of the bar graph (g401 to g405) of the first range to the N-th range is supposed to be a crest, the state determination unit 33 calculates the effect that the peak of the crest is in the third range, and performs storage processing to the effect that the peak is in the third range.

Next, the state determination unit 33 determines whether or not there are peaks indicating the same frequency in the frequency distribution input from the statistical processing unit 32 (Step S104). In this case, when a set of the bar graph of the first range to the N-th range is supposed to be a crest, since there are a plurality of peaks of the same height in the crest, the frequency distribution does not become a normal distribution. The BMS 25 determines that the cell assembly 10 is in a state where an abnormality is predicted (Step S105), and outputs the determination result to the output unit 34 (Step S 108).

In Step S104, when there are no peaks of the same value in the frequency distribution (that is, when there is one maximum peak at which the frequency is maximal between the ranges), the state determination unit 33 determines (a) whether there is a different peak, and (b) whether or not the proportion (ratio) of the frequency of a range to to which the different peak belongs with respect to the frequency of the range to which the maximum peak belongs is smaller than or equal to a predetermined value (Step S106).

Specifically, in regard to (b), if the frequency of the range to which the maximum peak belongs is Pm, and the frequency of the range to which the different peak belongs is Pc (m and c are positive integers smaller than or equal to N, and m≠c), the state determination unit 33 determines whether or not Expression (3) is satisfied.

$$Pc \leq Pm/T \ \dots \ (3)$$

Here, T is a positive integer, and is a numerical value which defines how much the height of the maximum peak protrudes with respect to the different peak. A way to set the value of T is defined in advance depending on the specification of the secondary battery 11 or the secondary battery abnormality prediction system by an experiment or the like. If the height of the different peak is about 25% of the height of the maximum peak, in general, since it can be considered that the peak of the crest is substantially one, it is preferable that 4≤T.

In this way, when Expression (3) is satisfied, it is determined (deemed) that the frequency distribution is a normal distribution. When there is no different peak or Expression (3) is satisfied (Yes in Step S106), the BMS 25 determines that the cell assembly 10 is in the normal state (Step S107), and outputs the determination result to the output unit 34 (Step S108). In this embodiment, for example, description will be continued assuming that T=7.

For example, in the frequency distribution shown in FIG. 6, there is one inflection point in the range of the bar g403, and the frequency of the range representing the maximum peak becomes the frequency of the range of the bar g403. Since there is no different peak, the determination through Expression (3) is not executed, and it is determined that the frequency distribution is a normal distribution.

FIG. 7 shows another example of a frequency distribution. The calculation result of the difference Zn in frequency between the ranges of the frequency distribution shown in FIG. 7 is as follows. That is, $Z_{(1)}$ becomes "the frequency $P_1$-0 belonging to the first range=positive value", $Z_{(2)}$ becomes "the frequency $P_2$ belonging to the second range-the frequency $P_1$ belonging to the first range=negative value", $Z_{(3)}$ becomes "the frequency $P_3$ belonging to the third range-the frequency $P_2$ belonging to the second range=positive value", $Z_{(4)}$ becomes "the frequency $P_4$ belonging to the fourth range-the frequency $P_3$ belonging to the third range=negative value", and $Z_{(5)}$ becomes "the frequency $P_5$ belonging to the fifth range-the frequency $P_4$ belonging to the fourth range=negative value". There are two peaks at points of a bar g411 and a bar g413.

As described above, since the frequency of the range to which each peak belongs is input to the state determination unit 33 in association with the range (that is, each frequency Pn is input in association with the range number of the range in which each frequency Pn is calculated), it is possible to determine a range which has the maximum peak, thereby determining that the frequency of the bar g413 is the maximum peak.

Next, the state determination unit 33 determines whether or not the relationship the frequency of the different peak (bar g411)≤(the frequency of the bar g413 as the maximum peak)/7 is satisfied based on Expression (3).

When the relationship of Expression (3) is satisfied, while there are a plurality of peaks, it is deemed that the frequency distribution is a normal distribution, and it is thus determined that the cell assembly 10 is in the normal state.

When the relationship of Expression (3) is not satisfied, that is, when there is an non-negligible different peak in addition to the maximum peak, it is not deemed that the frequency distribution is a normal distribution, and it is determined that an abnormality in the cell assembly 10 is predicted.

Although in the example shown in FIG. 7, the number of peaks is two in total, it will be shown that the same determination can be made when the number of peaks is three or more, and thus description will be omitted.

After the above-described prediction determination processing is performed, the state determination unit 33 outputs the determination result to the output unit 34, and ends the prediction determination in Step S5 of FIG. 4.

Even when any secondary battery 11 of the first secondary battery 11a to the 20th secondary battery 11t is replaced after the start of use, it may be determined to be the distribution shown in FIG. 7. In this case, it is assumed that the user intentionally provides variation in the deterioration state, and the BMS 25 may hold information regarding to the replacement in the memory (not shown), and may start prediction determination processing after a predetermined time elapses (for example, after a voltage is balanced to some extent by a balance circuit (not shown).

Returning to FIG. 4, when no abnormality is predicted (that is, the state determination unit 33 determines that the cell assembly 10 is in the normal state) based on the result of prediction determination in the state determination unit 33, the output unit 34 ends the processing. In this case, the output unit 34 may perform display to the effect that the cell assembly 10 is normal on the display unit 40 through the host control device 18. In Step S6, when an abnormality in the cell assembly 10 is predicted, the output unit 34 performs control such that a notification unit (for example, the display unit 40) gives notification of abnormality prediction through the host control device 18 (Step S7). As the notification of abnormality prediction, for example, it is considered that a character string, a symbol, or the like including the content of abnormality prediction is displayed on the display unit 40. In addition to or instead of the display on the display unit 40, abnormality prediction may be output by sound, or a hazard lamp or the like in an electric vehicle may be turned on.

The display to the effect that an abnormality is predicted may be, for example, performed such that the shape of the frequency distribution is displayed in the form of a graph (for example, bar graph). For example, the numbers of the first secondary battery 11a to the 20th secondary battery 11t corresponding to the voltage values $V_1$ to $V_{20}$ included in the bars g of the bar graph to be displayed or other kinds of information for identifying the first secondary battery 11a to the 20th secondary battery 11t may be displayed.

Although in this embodiment, an example where an abnormality is predicted using the voltage values $V_1$ to $V_{20}$ of the first secondary battery 11a to the 20th secondary battery 11t of the cell assembly 10 has been described, abnormality prediction processing may be performed based on a plurality of different kinds of parameter values (for example, voltage value and temperature value), and the determination results may be displayed collectively. For example, when prediction determination is performed using two kinds of parameter values, it should suffice that, when an abnormality is predicted through prediction determination based on at least one parameter value, a notification unit may give notification that an abnormality is predicted. With this, it becomes possible to perform prediction determination with improved precision, and to realize secondary battery abnormality prediction system (battery system) with improved safety.

Next, the actions and effects of the first embodiment described above will be described.

As described above, in the technique of the related art, after the unit cell (for example, secondary battery) reaches the abnormal state the effect that the secondary unit cell is abnormal is notified to the user. For this reason, in some cases, the battery system cannot be operated despite the necessity of operating the battery system at the current point of time.

In this embodiment which has been accomplished in consideration of this problem as an example, first, before a secondary battery undergoes an abnormality, statistical processing is performed based on the parameter value or the like obtained from each secondary battery or the like to determine the state, thereby predicting the effect that the secondary battery becomes abnormal in future. Therefore, according to this embodiment, for example, it becomes possible to replace a secondary battery, which is likely to be abnormal, in advance, and to realize a secondary battery prediction system with improved safety.

Although as the method of statistical processing, for example, there are various methods of calculating a standard deviation, a dispersion, or the like, the introduction of complex calculation processing, or the like causes an increase in the processing load of the BMS 25.

Since the BMS 25 which is mounted in the battery system performs the calculation of important information relating to the cell assembly 10 in addition to the calculation of the SOC or the like, it is preferable that the load of the statistical processing is low. According to this embodiment, the parameter value obtained from each secondary battery 11 is sorted into each predetermined range to generate the frequency distribution, and the frequencies between adjacent ranges are calculated to predict an abnormality of each secondary battery 11. For this reason, it becomes possible to determine abnormality prediction of each secondary battery 11 with a small processing load and to suppress adverse effects on calculation processing in other kinds of important information.

As described above, the secondary battery abnormality prediction system 1 of this embodiment performs statistical processing based on the parameter values (the above-described voltage, temperature, case voltage, and the like) representing the states of the secondary batteries, and predicts an abnormality of the cell assembly 10 based on the state of each parameter value. As a result, the secondary battery abnormality prediction system 1 can give notification that a secondary battery is likely to fall into an abnormal state before the secondary battery is in the abnormal state, can give notification of the secondary battery, or the like.

Although in this embodiment, an example where the state determination unit 33 counts the number of maximum values and determines whether or not there are a plurality of maximum values has been described, the state determination unit 33 may count the number of minimum values.

The invention is not limited to the content described in the first embodiment, and various modifications may be made without departing from the scope of the invention. Hereinafter, another embodiment of the invention will be described.

[Second Embodiment]

Hereinafter, a second embodiment will be described. This embodiment is different from the first embodiment in that an abnormality (for example, failure) of a specified equipment (for example, a cooling device or the like) is estimated based on the state of a parameter value distribution, and other points are the same as the first embodiment. Therefore, description of the points overlapping the first embodiment will be appropriately omitted, and description will be provided focusing on the distinctive difference.

In this embodiment, a case where the determination processing is performed using the temperature value as the parameter value, and a distribution shown in FIG. 7 having two maximum values, that is, two peaks is obtained will be described. The state determination unit 33 determines whether or not the numbers of a plurality of secondary batteries 11 sorted in the bar g411 (as described above, the number corresponding to each secondary battery 11 is set in advance) concentrate on a specific position in the actual arrangement of the secondary batteries 11 of the cell assembly 10. For example, when a plurality of secondary batteries are stored in a module case to form a cell assembly 10, it is determined whether or not the temperature values of a plurality of secondary batteries arranged near a cooling device (not shown) in the module case are sorted in the bar g411.

As a result of the determination, when each secondary battery which is sorted in the bar g411 having a different peak instead of the bar g413 having the maximum peak concentrates on a specific position (for example, in the vicinity of the cooling device) , there is a possibility that the cooling device fails.

For this reason, as in the first embodiment, the BMS 25 (state determination unit 33 and output unit 34) performs control such that information of the cooling device which is likely to fail is notified to the notification unit, in addition to the control such that display is performed to the effect that an abnormality in each secondary battery 11 constituting the cell assembly 10 is predicted.

According to this embodiment, in addition to the effects of the first embodiment, it is possible to specify a device (for example, if the parameter value is the temperature value, the cooling device) which is likely to fail, and to realize a secondary battery abnormality prediction system with improved safety and reliability.

It is preferable that the state of a parameter distribution when an abnormality or a failure case occurs is acquired by the manufacture of the secondary battery abnormality prediction system in advance or calculated by a simulation or the like, and the state of each distribution is stored in the state determination unit 33 in association with the parameter.

In this way, if the state of the distribution is stored in advance in association with the parameter, and is compared with the state of the parameter distribution measured at the current time, it is possible to determine a state where an abnormality or failure is likely to occur hereafter.

Although in this embodiment, as shown in FIG. 1, an example where the CMU 20 and the BMU 30 are provided as the BMS 25 has been described, the invention is not limited thereto, and the function of the CMU 20 may be integrated into the BMU 30. Part of the prediction determination processing which is performed by the BMU 30 may be appropriately performed by the host control device 18, such that prediction determination may be performed by a control device.

The statistical processing unit 32 may perform other kinds of known statistical processing on parameter values based on a plurality of parameter values without affecting other kinds of processing and calculation which are performed by the BMS 25. Examples of other kinds of statistical processing include the calculation of the average value, the standard deviation value, or the dispersion value of the acquired parameter values.

A program for realizing the functions of the respective units of the CMU 20 and the BMU 30 of the embodiment shown in FIG. 1 may be recorded in a computer-readable recording medium, and the program recorded in the recording medium may be read onto a computer system and executed to perform the processing of the units. The term "computer system" used herein includes an OS or hardware, such as peripherals.

The term "computer system" includes a homepage providing environment (or display environment) when a WWW system is used. The term "computer-readable recording medium" refers to a portable medium, such as a flexible disk, a magneto-optical disk, a ROM (Read Only Memory), or a CD-ROM, or a storage device, such as a USB memory which is connected through a USB (Universal Serial Bus) I/F (interface) or a hard disk which is embedded in the computer system. The term "computer-readable recording medium" includes a volatile memory in a computer system serving as a server or a client in which a program is held for a given time. The program may realize some of the above-described functions, and the above-described functions may be realized in combination with a program which is already recorded in the computer system.

Industrial Applicability

The invention relates to a battery abnormality prediction system including a normal range determination unit which acquires parameter values representing the states of a plurality of unit cells and determines whether or not the acquired parameter values are normal values, a statistical processing unit which sorts a plurality of parameter values determined to be normal values in ranges divided at predetermined intervals and performs statistical processing on the sorted parameter values,

and a state determination unit which determines the states of the plurality of unit cells based on the result of the statistical processing in the statistical processing unit and determines whether or not the plurality of unit cells are in a state of being able to transit from a normal state to an abnormal state based on the determination result. According to the invention, it is possible to predict a unit cell which is likely to fall into an abnormal state before a plurality of unit cells mounted in a system fall into the abnormal state while suppressing a processing load necessary for determination. Therefore, it is possible to realize a battery system having an excellent degree of safety.

Reference Signs List

| 1: | secondary battery abnormality prediction system |
| 10: | cell assembly |
| 11a to 11t: | secondary battery |
| 20: | CMU (Cell Monitor Unit) |
| 21: | parameter value output unit |
| Ia, Ib: | ammeter |
| Va to Vh, 24: | voltmeter |
| 30: | BMU (Battery Management Unit) |
| 40: | display unit |
| 50: | power load |
| Ta to Th: | thermometer |
| 31: | normal range determination unit |
| 32: | statistical processing unit |
| 33: | state determination unit |
| 34: | output unit |

Claims

1.   A battery abnormality prediction system comprising:

a normal range determination unit which acquires parameter values representing the states of a plurality of unit cells and determines whether or not the acquired parameter values are normal values;
a statistical processing unit which sorts a plurality of parameter values determined to be normal values in ranges divided at predetermined intervals and performs statistical processing on the sorted parameter values; and
a state determination unit which determines the states of the plurality of unit cells based on the result of the statistical processing in the statistical processing unit and determines whether or not the plurality of unit cells are in a state of being able to transit from a normal state to an abnormal state based on the determination result.

**2.** The battery abnormality prediction system according to claim 1, wherein the statistical processing unit generates a frequency distribution based on the plurality of acquired parameter values and the divided ranges, and

the state determination unit determines the state of the frequency distribution based on a difference in frequency between adjacent ranges from among the divided ranges.

**3.** The battery abnormality prediction system according to claim 2, wherein the statistical processing unit sets the number of divisions based on a difference between an upper limit value and a lower limit value of each parameter value defining the normal value and the predetermined intervals, and

when the frequency distribution has a plurality of peaks, the state determination unit determines whether or not the plurality of unit cells are in a state of being able to transit from the normal state to the abnormal state based on a ratio of a frequency corresponding to a maximum peak and a frequency corresponding to a different peak.

**4.** The battery abnormality prediction system according to claim 3, further comprising:

a specified equipment, wherein the state determination unit determines that the specified equipment is abnormal, when there are the plurality of peaks, along with the unit cell sorted in the range where there is the different peak is arranged in the vicinity of the specified equipment.

**5.** The battery abnormality prediction system according to claim 4, further comprising:

a notification unit which gives notification of the determination result of the state determination unit.

FIG. 1

SECONDARY BATTERY ABNORMALITY
PREDICTION SYSTEM 1

CELL ASSEMBLY 10

# FIG. 2

# FIG. 3

| SECONDARY BATTERY NUMBER | SECONDARY BATTERY | VOLTAGE | SECONDARY BATTERY NUMBER | SECONDARY BATTERY | VOLTAGE |
|---|---|---|---|---|---|
| 1 | 1ST SECONDARY BATTERY | $V_1$ | 11 | 11ST SECONDARY BATTERY | $V_{11}$ |
| 2 | 2ND SECONDARY BATTERY | $V_2$ | 12 | 12ND SECONDARY BATTERY | $V_{12}$ |
| 3 | 3RD SECONDARY BATTERY | $V_3$ | 13 | 13RD SECONDARY BATTERY | $V_{13}$ |
| 4 | 4TH SECONDARY BATTERY | $V_4$ | 14 | 14TH SECONDARY BATTERY | $V_{14}$ |
| 5 | 5TH SECONDARY BATTERY | $V_5$ | 15 | 15TH SECONDARY BATTERY | $V_{15}$ |
| 6 | 6TH SECONDARY BATTERY | $V_6$ | 16 | 16TH SECONDARY BATTERY | $V_{16}$ |
| 7 | 7TH SECONDARY BATTERY | $V_7$ | 17 | 17TH SECONDARY BATTERY | $V_{17}$ |
| 8 | 8TH SECONDARY BATTERY | $V_8$ | 18 | 18TH SECONDARY BATTERY | $V_{18}$ |
| 9 | 9TH SECONDARY BATTERY | $V_9$ | 19 | 19TH SECONDARY BATTERY | $V_{19}$ |
| 10 | 10TH SECONDARY BATTERY | $V_{10}$ | 20 | 20TH SECONDARY BATTERY | $V_{20}$ |

FIG. 4

```
                    ┌─────────────┐
                    │    START    │
                    └──────┬──────┘
                           │
                           ▼
              ┌──────────────────────────┐
              │   ACQUIRE VOLTAGE VALUE   │──── S1
              └────────────┬─────────────┘
                           │
                           ▼
                         ╱   ╲
                       ╱  S2   ╲
                     ╱  VOLTAGE   ╲
                   ╱  VALUES OF ALL  ╲   NO
                  ◇ SECONDARY BATTERIES ◇────────┐
                   ╲    ARE          ╱            │
                     ╲ ACQUIRED?   ╱              │
                       ╲        ╱                 │
                         ╲ YES╱                   │
                           │                      │
                           ▼                      │
                         ╱   ╲                    │
                       ╱  S3   ╲                  │
                     ╱ VOLTAGE    ╲               │
                   ╱  VALUES OF ALL ╲   NO         │
                  ◇ SECONDARY BATTERIES◇────┐     │
                   ╲ ARE WITHIN     ╱        │     │
                     ╲NORMAL RANGE?╱         │     │
                       ╲        ╱            │     │
                         ╲ YES╱              │     │
            S5             │                 │     │
             │             ▼                 ▼     │
   ┌─────────────────────────┐    ┌────────────────────┐
   │ PREDICTION DETERMINATION│    │ WARNING PROCESSING │─ S4
   └───────────┬─────────────┘    └─────────┬──────────┘
               │                            │
               ▼                            │
             ╱   ╲                          │
           ╱  S6   ╲   YES                   │
          ◇ABNORMALITY◇──────┐              │
           ╲IS PREDICTED?╱    │  S7          │
             ╲        ╱       ▼              │
               ╲ NO╱  ┌──────────────────┐  │
                │     │ GIVE NOTIFICATION │  │
                │     │    OF RESULT      │  │
                │     └─────────┬─────────┘  │
                │               │            │
                ▼◄──────────────┴────────────┘
          ┌─────────────┐
          │     END     │
          └─────────────┘
```

## FIG. 5

```
              ( START )
                  │
                  ▼
   ┌──────────────────────────────┐
   │   SET NUMBER OF DIVISIONS     │──── S101
   └──────────────────────────────┘
                  │
                  ▼
   ┌──────────────────────────────┐
   │   SORT ACQUIRED VOLTAGE       │──── S102
   │   VALUE IN EACH RANGE         │
   └──────────────────────────────┘
                  │
                  ▼
   ┌──────────────────────────────┐
   │     CALCULATE PEAK            │──── S103
   └──────────────────────────────┘
                  │
                  ▼           S104
            ╱──────────╲
           ╱  THERE IS   ╲      YES
          ╱ PEAK OF SAME  ╲──────────────────────┐
           ╲  VALUE?      ╱                       │
            ╲──────────╱                          │
                  │ NO                            │
                  ▼              S106             │
           ╱──────────────╲                       │
          ╱  (a)THERE IS    ╲                      │
         ╱ NO DIFFERENT PEAK ╲                     │
        ╱ OR (b)RATIO OF      ╲    NO              │
       ╱ DIFFERENT PEAK WITH   ╲──────────┐        │
        ╲ RESPECT TO MAXIMUM   ╱          │        │
         ╲ PEAK IS EQUAL TO OR╱           │        │
          ╲ SMALLER THAN     ╱            │        │
           ╲ PREDETERMINED  ╱             │        │
            ╲  VALUE?      ╱              │        │
             ╲──────────╱                │        │
                  │ YES          S107     ▼        ▼   S105
                  ▼                   ┌──────────────────────────┐
   ┌──────────────────────────┐      │ DETERMINE AS STATE WHERE │
   │  DETERMINE AS STATE WHERE │      │ ABNORMALITY IS PREDICTED │
   │  CELL ASSEMBLY IS NORMAL  │      │     IN CELL ASSEMBLY     │
   └──────────────────────────┘      └──────────────────────────┘
                  │                            │
                  ▼◄───────────────────────────┘
   ┌──────────────────────────────┐
   │  OUTPUT DETERMINATION RESULT  │──── S108
   └──────────────────────────────┘
                  │
                  ▼
              (  END  )
```

FIG. 6

FIG. 7

## INTERNATIONAL SEARCH REPORT

| International application No. |
|---|
| PCT/JP2011/073425 |

**A. CLASSIFICATION OF SUBJECT MATTER**
*G01R31/36*(2006.01)i, *H01M10/48*(2006.01)i

According to International Patent Classification (IPC) or to both national classification and IPC

**B. FIELDS SEARCHED**

Minimum documentation searched (classification system followed by classification symbols)
G01R31/36, H01M10/48

Documentation searched other than minimum documentation to the extent that such documents are included in the fields searched
| | | | |
|---|---|---|---|
| Jitsuyo Shinan Koho | 1922-1996 | Jitsuyo Shinan Toroku Koho | 1996-2011 |
| Kokai Jitsuyo Shinan Koho | 1971-2011 | Toroku Jitsuyo Shinan Koho | 1994-2011 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y<br>A | JP 2007-309839 A (Fuji Electric Systems Co., Ltd.),<br>29 November 2007 (29.11.2007),<br>paragraphs [0020] to [0038]<br>(Family: none) | 1<br>2-5 |
| Y<br>A | JP 10-322925 A (Nissan Motor Co., Ltd.),<br>04 December 1998 (04.12.1998),<br>paragraph [0017]<br>& US 5998969 A | 1<br>2-5 |

☐ Further documents are listed in the continuation of Box C.   ☐ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 28 December, 2011 (28.12.11) | 17 January, 2012 (17.01.12) |

| Name and mailing address of the ISA/ | Authorized officer |
|---|---|
| Japanese Patent Office | |
| Facsimile No. | Telephone No. |

Form PCT/ISA/210 (second sheet) (July 2009)

**EP 2 637 032 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2010247675 A
- JP 2008118790 A
- JP 2003125540 A